(19) Europäisches Patentamt
European Patent Office
Office européen des brevets

(11) EP 3 038 143 A1

(12) EUROPEAN PATENT APPLICATION
published in accordance with Art. 153(4) EPC

(43) Date of publication:
29.06.2016 Bulletin 2016/26

(51) Int Cl.:
H01L 21/338 (2006.01)     H01L 21/225 (2006.01)
H01L 29/778 (2006.01)     H01L 29/812 (2006.01)

(21) Application number: 13891799.2

(22) Date of filing: 19.08.2013

(86) International application number:
PCT/JP2013/072061

(87) International publication number:
WO 2015/025349 (26.02.2015 Gazette 2015/08)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: Fujitsu Limited
Kawasaki-shi, Kanagawa 211-8588 (JP)

(72) Inventor: ENDOH Akira
Kawasaki-shi
Kanagawa 211-8588 (JP)

(74) Representative: Cooper-Rolfe, Elizabeth Louise
Haseltine Lake LLP
Lincoln House, 5th Floor
300 High Holborn
London WC1V 7JH (GB)

(54) FIELD EFFECT COMPOUND SEMICONDUCTOR DEVICE

(57) Disclosed is a field effect compound semiconductor device wherein both reduction of sheet resistance due to high-concentration $\delta$-doping, and reduction of remote Coulomb scattering are achieved. A planar doped layer that is planarly doped with impurity atoms to be a channel electron supply source is provided in a lower barrier layer and/or an upper barrier layer, and a barrier layer portion in contact with a channel layer is formed as a III-V compound semiconductor spacer layer wherein a group V element is Sb.

FIG.1

**Description**

TECHNICAL FIELD

The present invention relates to a field-effect compound semiconductor device such as a high-electron-mobility transistor (HEMT) which is a high-speed transistor.

BACKGROUND ART

High-electron-mobility transistors (HEMTs) using III-V group compound semiconductors are high-speed transistors capable of operating in a milliwave (30 GHz to 300 GHz) to sub-milliwave (300 GHz to 3 THz) range. Among them, InP HEMTs using an InAlAs/InGaAs junction structure are field-effect transistors which presently have the world's highest speed at a cut-off frequency $f_T$ = 688 GHz (see, for example, Non-Patent Literature 1).

The cut-off frequency $f_T$, which is one of the indicators of high speed ability of the HEMTs, can be represented as

$$f_T = 1/\{2\pi(L_g/v + \tau_{ex})\} \qquad ...(1)$$

where $L_g$ is a gate length, $v$ is an electron velocity under the gate electrode, and $\tau_{ex}$ is a parasitic delay time. The increase in HEMT speed is mainly achieved by miniaturizing the gate length $L_g$ and increasing the electron velocity $v$ by using a semiconductor with a small effective mass of electrons for the channel. Those measures are equivalent to the reduction of the intrinsic delay time (= $L_g/v$) of the HEMT.

However, the ratio of the parasitic delay time $\tau_{ex}$ in the total delay time has recently become relatively large due to a significant decrease in the intrinsic delay time, and the decrease in the parasitic delay time has also become an important problem in terms of speed increase.

The effect of source resistance or drain resistance is one of the factors contributing to the parasitic delay time $\tau_{ex}$. The source (drain) resistance is constituted by an ohmic contact resistance and sheet resistance of the channel layer. Among them, the sheet resistance can be reduced by increasing the electron density in the channel layer. Accordingly, an attempt has been made to increase the Si-$\delta$ doping amount in the InAlAs electron supply layer above the InGaAs channel layer.

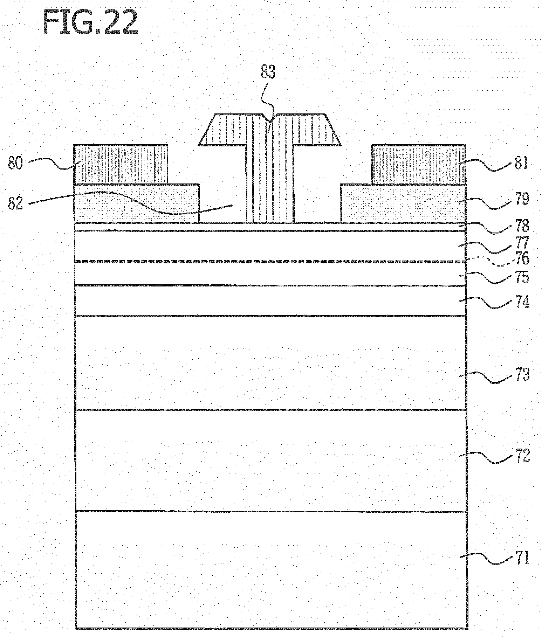

High-concentration doping of $1 \times 10^{13}$ cm$^{-2}$ or higher is presently performed as the Si-$\delta$ doping. An InP HEMT will be explained hereinbelow with reference to Fig. 22. Fig. 22 is a schematic cross-sectional view of the conventional InP HEMT. As illustrated in the figure, an i-type $In_{0.52}Al_{0.48}As$ buffer layer 72, an i-type $In_{0.52}Al_{0.48}As$ lower barrier layer 73, an i-type InGaAs channel layer 74, and an i-type $In_{0.52}Al_{0.48}As$ spacer layer 75 are successively deposited on a semi-insulating InP substrate 71.

Then, a $\delta$ doped layer 76 is formed by $\delta$ doping Si, and an i-type $In_{-0.52}Al_{0.48}As$ barrier layer 77 and an i-type InP layer 78 are thereafter successively deposited. Those i-type $In_{0.52}Al_{0.48}As$ spacer layer 75 through the i-type InP layer 78 serve as an upper barrier layer. The i-type InP layer is provided to prevent the exposure of the i-type $In_{0.52}Al_{0.48}As$ barrier layer 77 which is an Al-containing layer. Then, a source electrode 80 and a drain electrode 81 are provided, with an n-type InGaAs cap layer 79 being located therebelow. A gate electrode 83 is provided in a gate recess portion 82.

The sheet resistance $R_{sheet}$ of the HEMT can be represented as

$$R_{sheet} = 1/(eN_s\mu) \qquad ...(2)$$

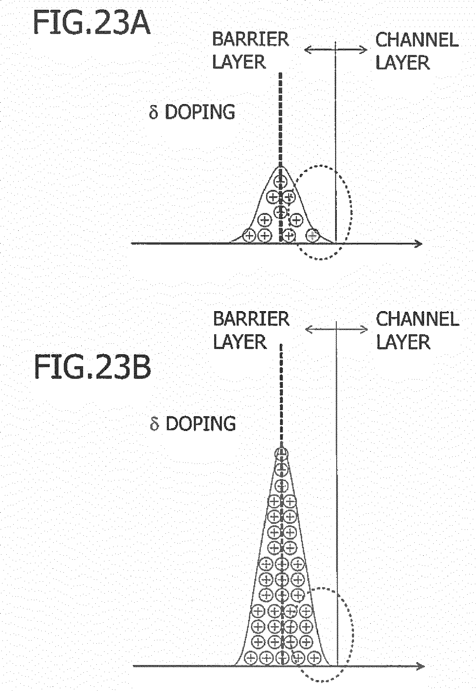

where $N_s$ is an electron density, $\mu$ is an electron mobility, and e is an elementary charge. As a result of performing the high-concentration Si-$\delta$ doping, the electron density in the channel layer could be increased. However, the problem arising due to the high-concentration Si-$\delta$ doping is that the diffusion amount of Si increases. This issue will be described hereinbelow with reference to Figs. 23A and 23B.

Figs. 23A and 23B is an explanatory drawing illustrating the distribution of Si after $\delta$ doping, Fig. 23A is the distribution diagram in the case of low-concentration 5 doping, and Fig. 23B is the distribution diagram in the case of high-concentration $\delta$ doping. As illustrated in Fig. 23A, Si introduced by $\delta$ doping does not remain "as is" at the initial doping position. Since the growth of the barrier layer or cap layer is performed at a high temperature after the Si-$\delta$ doping, the Si which had a substantially $\delta$-function distribution immediately after the doping diffuses up and down in the thickness direction of the grown layer.

Even when the growth temperature or growth time is the same, where the Si-$\delta$ doping concentration is high, Si diffuses closer to the channel layer, as illustrated in Fig. 23B. Si which is a donor is ionized and, even while remaining in the spacer layer, exerts a Coulomb force to the electrons in the channel layer and causes the remote Coulomb scattering. In particular, since the Coulomb force is inversely proportional to the square of the distance, where the scattering source present in the upper barrier layer approaches the channel layer, the channel electron mobility is greatly reduced and the sheet resistance increases.

The Si-$\delta$ doping method can also have another configuration. In the aforementioned Non-Patent Literature 1 describing how the world's highest speed has been achieved, Si-$\delta$ doping, which is the source of electron supply to the channel layer, is provided in two locations in the InAlAs barrier layer. With such a method, it is possible to increase the electron concentration in the channel layer and reduce the sheet resistance.

However, since the Si doping amount is increased, the diffusion of Si in the channel layer direction in the crystal growth or processing increases over that in the case of a single location of Si-$\delta$ doping. This is because the diffusion of Si in the up-down direction becomes asymmetric due to Si-$\delta$ doping in two locations. In particular, with the Si-$\delta$ doping close to the channel, the diffusion in the channel direction is large, whereas the diffusion in the opposite direction is small.

Si is prevented from diffusing into the channel layer by providing the spacer layer. However, since the amount of Si at a position close to the channel layer increases, the effect of remote Coulomb scattering is enhanced and the electron mobility in the channel layer decreases. For this reason, since the electron mobility $\mu$ decreases even when the electron concentration Ns is increased by the double Si-$\delta$ doping, the double doping fails to reduce the resistance by half.

Meanwhile, a double doped structure is also known in which Si-$\delta$ doping has been performed above and below an InGaAs channel layer in order to increase the electron concentration in the channel layer. In a HEMT using such a structure the cut-off frequency $f_T$ is reported to be 660 GHz (see, for example, Non-Patent Literature 2). However, in this structure, the diffusion of Si-$\delta$ doping in the lower barrier layer is larger than the diffusion of Si-$\delta$ doping in the upper barrier layer. As a result, the channel electron concentration is difficult to increase while suppressing the effect of Si diffusion.

CITATION LIST

NON- PATENT LITERATURE

Non-Patent Literature 1: Kim et al., IEDM Tech. Dig., no. 13.6, Dec. 2011
Non-Patent Literature 2: Leuther et al., Proc. 23rd IPRM, no. Tu-4. 2. 2, p. 295, May 2011
Non-Patent Literature 3: M. E. Greiner and J. F. Gibbonset, Appl. Phys. Lett. Vol. 44, p. 750, 1984

SUMMARY OF INVENTION

PROBLEMS TO BE SOLVED BY THE INVENTION

As mentioned hereinabove, because of high-concentration $\delta$ doping of Si, the diffusion of Si increases and the ionized Si comes closer to the channel layer. As a result, the remote Coulomb scattering caused by the ionized Si in the barrier layer increases. Since the Coulomb force is inversely proportional to the square of the distance, the ionized Si which has approached the channel layer demonstrates a prominent effect, and the remote Coulomb scattering causes the decrease in the channel electron mobility. The resultant problem is that sheet resistance increases and does not decrease as expected.

Thus, it is an objective to reduce the sheet resistance which is due to high-concentration $\delta$ doping and also to reduce the remote Coulomb scattering in a field-effect compound semiconductor device.

MEANS FOR SOLVING THE PROBLEMS

A field-effect compound semiconductor device comprising:

a semiconductor substrate;
a lower barrier layer that is provided on the semiconductor substrate;
a channel layer that is provided in contact with the lower barrier layer;
an upper barrier layer that is provided in contact with the channel layer;
a cap layer that is provided in contact with the upper barrier layer;
a source electrode and a drain electrode that are provided on the cap layer; and
a gate electrode that is arranged between the source electrode and the drain electrode, wherein

a planar doped layer that is planarly doped with impurity atoms, which are to be a channel electron supply source, is provided in at least one of the lower barrier layer and the upper barrier layer; and

a portion of the barrier layer, where the planar doped layer has been provided, is a III-V group compound semiconductor spacer layer in which a V group element is Sb, with this portion being in contact with the channel layer.

ADVANTAGEOUS EFFECTS OF THE INVENTION

In the disclosed field-effect compound semiconductor device, both the reduction in the sheet resistance, which is due to high-concentration $\delta$ doping, and the reduction in the remote Coulomb scattering can be achieved.

BRIEF DESCRIPTION OF DRAWINGS

Fig. 1 is a schematic cross-sectional view of a field-effect compound semiconductor device of an embodiment of the present invention.
Fig. 2 is an explanatory drawing of an impurity diffusion model.
Fig. 3 is an explanatory drawing of impurity diffusion calculation results.
Fig. 4 is an explanatory drawing of a remote Coulomb scattering calculation model.
Fig. 5 is a schematic cross-sectional view of the HEMT of Example 1 of the present invention.
Fig. 6 is an explanatory drawing illustrating first part of the process for manufacturing the HEMT of Example 1 of the present invention.
Fig. 7 is an explanatory drawing illustrating first part of the process for manufacturing the HEMT of Example 1 of the present invention after the process illustrated by Fig. 6.
Fig. 8 is an explanatory drawing illustrating first part of the process for manufacturing the HEMT of Example 1 of the present invention after the process illustrated by Fig. 7.
Fig. 9 is an explanatory drawing illustrating first part of the process for manufacturing the HEMT of Example 1 of the present invention after the process illustrated by Fig. 8.
Fig. 10 is an explanatory drawing illustrating first part of the process for manufacturing the HEMT of Example 1 of the present invention after the process illustrated by Fig. 9.
Fig. 11 is an explanatory drawing illustrating first part of the process for manufacturing the HEMT of Example 1 of the present invention after the process illustrated by Fig. 10.
Fig. 12 is an explanatory drawing illustrating first part of the process for manufacturing the HEMT of Example 1 of the present invention after the process illustrated by Fig. 11.
Fig. 13 is an explanatory drawing illustrating first part of the process for manufacturing the HEMT of Example 1 of the present invention after the process illustrated by Fig. 12.
Fig. 14 is an explanatory drawing illustrating first part of the process for manufacturing the HEMT of Example 1 of the present invention after the process illustrated by Fig. 13.
Fig. 15 is an explanatory drawing illustrating first part of the process for manufacturing the HEMT of Example 1 of the present invention after the process illustrated by Fig. 14.
Fig. 16 is a schematic cross-sectional view of the HEMT of Example 2 of the present invention.
Fig. 17 is a schematic cross-sectional view of the HEMT of Example 3 of the present invention.
Fig. 18 is a schematic cross-sectional view of the HEMT of Example 4 of the present invention.
Fig. 19 is a schematic cross-sectional view of the HEMT of Example 5 of the present invention.
Fig. 20 is a schematic cross-sectional view of the HEMT of Example 6 of the present invention.
Fig. 21 is a schematic cross-sectional view of the HEMT of Example 7 of the present invention.
Fig. 22 is a schematic cross-sectional view of the conventional HEMT.
Fig. 23A and Fig.23B are is schematic diagrams illustrating the diffusion of impurities.

DESCRIPTION OF EMBODIMENTS

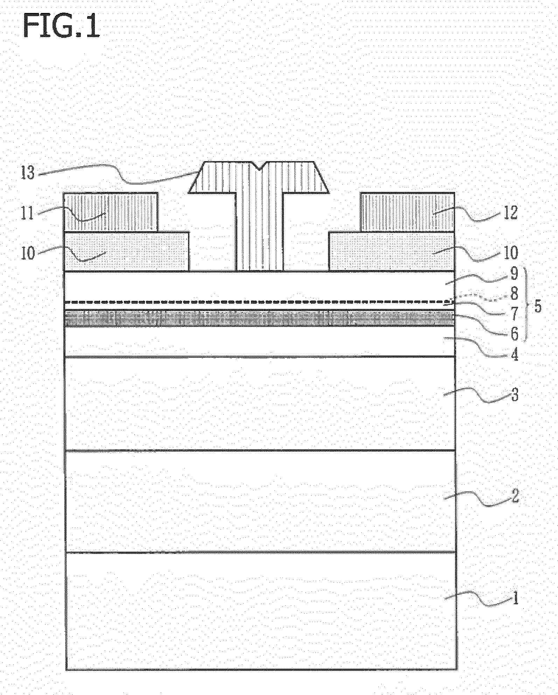

The field-effect compound semiconductor devices of the embodiments of the present invention will be described hereinbelow with reference to Figs. 1 to 4. Fig. 1 is a schematic cross-sectional view of a field-effect compound semiconductor device of an embodiment of the present invention. As illustrated in the figure, a buffer layer 2, a lower barrier layer 3, and a channel layer 4 are successively formed on a semiconductor substrate 1. Then, a III-V group compound semiconductor spacer layer 6 in which a V group element is Sb and a spacer layer 7 are successively deposited, a planar doped layer 8 is thereafter formed by $\delta$ doping of Si, and then a barrier layer 9 is formed. Layers from the III-V group compound semiconductor spacer layer 6 through the barrier layer 9 constitute an upper barrier layer 5. Then, a source electrode 11 and a drain electrode 12 are provided, with a cap layer 10 being disposed therebelow, and a gate electrode 13 is provided in a gate recess portion. When the lower barrier layer 3 is lattice matched to the semiconductor substrate 1, the buffer layer 2 and the lower barrier layer 3 become the same semiconductor layer. However when the lattices are not matched, using a composition-graded semiconductor layer as the buffer layer 2 and forming the layer such that the lattice constant of the uppermost portion of the buffer layer 2 matches the lattice constant of the lower barrier layer 3 are needed. A molecular beam epitaxy (MBE) method is typically used for layer deposition, but a metalorganic vapor phase epitaxy method (MOVPE) may be also used.

Since Si does not act as a donor in the III-V group compound semiconductor spacer layer 6 in which a V group element is Sb, the ionized Si which causes the remote Coulomb scattering is not present in the III-V group compound semiconductor spacer layer 6. Therefore, the decrease in channel electron mobility caused by the remote Coulomb scattering can be suppressed. Incidentally, in the III-V group compound semiconductor in which a V group element is Sb, Te is used as a donor impurity.

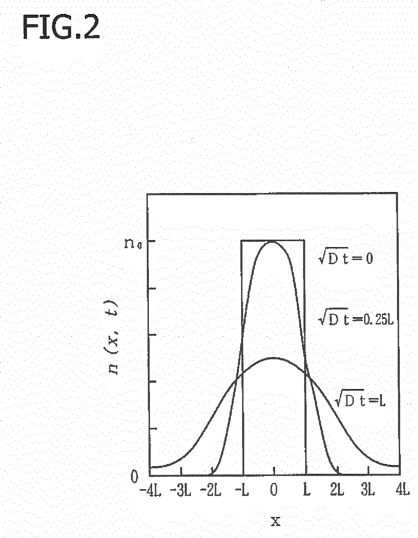

Fig. 2 is an explanatory drawing of an impurity diffusion model. The rectangle in the figure illustrates the state in which an impurity is $\delta$ doped at a concentration of no in a range with a position x in the lamination direction from -L to +L, that is, the state with $(Dt)^{1/2} = 0$. Here D is the diffusion coefficient of the impurity, t is a heat treatment time, that is, the period of time in which crystal growth is performed on the planar doped layer, and $(Dt)^{1/2}$ is a diffusion length.

The impurity concentration distribution n(x, t) after the diffusion caused by the heat treatment is represented as:

$$n(x, t) = (n_0/2)\{erf(A) + erf(B)\} \; @ \; |x| \leq L \qquad \qquad ...(3)$$

$$n(x, t) = (n_0/2)\{erf(A) - erf(B)\} \; @ \; |x| \geq L \qquad \qquad ...(4),$$

Here, erf(x) is an error function, and A and B are

$$A = (L + |x|)/\{2(Dt)^{1/2}\}$$

$$B = (L - |x|)/\{2(Dt)^{1/2}\}.$$

As illustrated in the figure, as the diffusion length increases, the impurity concentration distribution deviates from the steep $\delta$ function.

In the fabrication of an InP HEMT, the crystal growth is performed at about 480°C to 540°C, and the growth time after Si-$\delta$ doping is 2 min to 3 min. Under such conditions, the diffusion length is about $(Dt)^{1/2} = 0.5$ nm (see, for example, Non-Patent Literature 3).

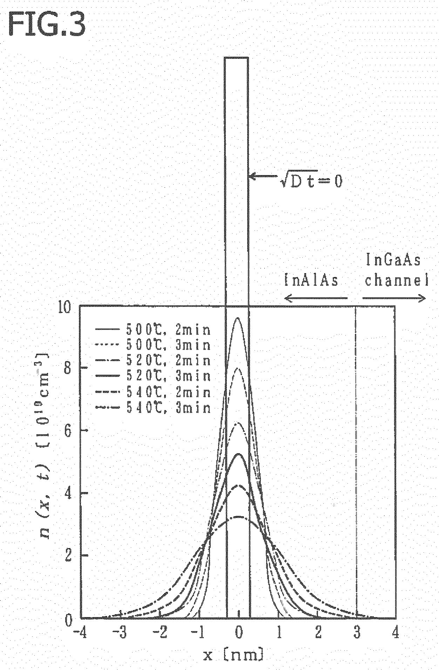

Fig. 3 is an explanatory drawing of impurity diffusion calculation results. The calculations were performed with respect to combinations of three temperature conditions, namely, 500°C, 520°C, and 540°C, and two growth times of 2 min and 3 min. In this case, L is about 0.3 nm where the Si-$\delta$ doping amount is taken as $1 \times 10^{13}$ cm$^{-2}$, Si is assumed to be $\delta$ doped within $\pm 1$ monolayer from the center, and the unevenness of an underlayer is taken to be of one monolayer. Therefore, $n_0 = 1.66 \times 10^{20}$ cm$^{-3}$. Fig. 3 illustrates the results obtained by calculating the distribution of Si from Expressions (3) and (4) above by using the aforementioned numerical values. In the case of an average temperature of 520°C and a time of 3 min, $(Dt)^{1/2} = 0.5$ nm.

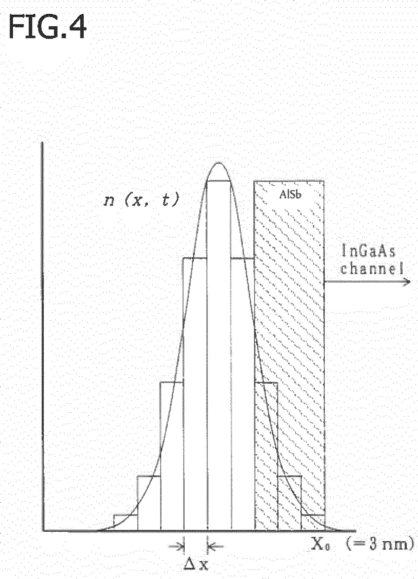

Fig. 4 is an explanatory drawing of a remote Coulomb scattering calculation model. In the mode, the spacer layer, that is, the distance from the interface of the channel layer and the upper barrier layer to the planar doped layer is 3 nm, the III-V group compound semiconductor spacer layer in which a V group element is Sb is 2 nm, and the remaining spacer layer is 1 nm. This configuration is compared with that in which the III-V group compound semiconductor spacer layer in which a V group element is Sb is not present and all 3 nm are taken by the composition same as that of the barrier layer. The calculation in this case is conducted under as assumption that the III-V group compound semiconductor spacer layer in which a V group element is Sb is AlSb and the remaining spacer layer is InAlAs.

In the calculation, the Coulomb force received by electrons on the channel layer/AlSb heterojunction interface from the ionized donor at each position x is integrated. Therefore, the total remote Coulomb force $F_{total}$ is a sum of Coulomb forces F(x) created by the donors present in regions divided by the width $\Delta x$. Where $x_0$ denotes the position of the heterojunction interface, e denotes an elementary charge, and $\varepsilon$ denotes a dielectric constant of the semiconductor,

$$F_{total} = \Sigma F(x) = \Sigma (4\pi\varepsilon)^{-1} \times n(x)\Delta x e^2/|x_0 - x|^2 = e^2/(4\pi\varepsilon)\Sigma n(x)\Delta x/|x_0 - x|^2.$$

In the case of 520°C, 3 min, and $(Dt)^{1/2}$ = 0.5 nm, the ratio of the electron concentration $n_{total(with\ AlSb)}$ obtained when AlSb is introduced to the electron concentration $n_{total(without\ AlSb)}$ obtained without the introduction of AlSb, that is, $n_{total(with\ AlSb)}/n_{total(without\ AlSb)}$, is about 0.914. It is clear that the reduction in the number of channel electrons caused by the introduction of AlSb is 10% or less.

As for the ratio of Coulomb forces which are created by ionized donors and received by channel electrons, where the ionized donor distribution is taken into account, the Coulomb forces appear to change significantly from the inverse proportionality to the square of the distance. The ratio of the Coulomb force $F_{total(with\ AlSb)}$ obtained when AlSb is introduced to the Coulomb force $F_{total(without\ AlSb)}$ obtained without the introduction of AlSb, that is, $F_{total(with\ AlSb)}/F_{total(without\ AlSb)}$, is about 0.573, that is, reduces to about half. Therefore, it is clear that the remote Coulomb scattering can be suppressed.

Incidentally, where the thickness of the AlSb spacer layer is taken as 2.5 nm, $n_{total(with\ AlSb)}/n_{total(without\ Al5b)}$ is about 0.754 and $F_{total(with\ Alsb)}/F_{total(without\ AlSb)}$ is about 0.410 and the Coulomb force is small, but the channel electron concentration decreases significantly. Therefore, it is desirable that the thickness of the III-V compound semiconductor spacer layer be 50% to 80% of the thickness between the channel layer/upper barrier layer interface and the planar doped layer.

Another advantage is that since the energy at the conduction band edge of AlSb is higher than that of InAlAs as a barrier, quantum-mechanical penetration of channel electrons into the barrier layer or the real spatial transition between the upper barrier layer and channel layer can be suppressed. The lattice constant of AlSb is significantly different from that of other layers, but when it is used as a spacer layer, a thickness of about 2 nm to 2.5 nm is sufficient. Therefore, strained AlSb can be grown without the degradation of crystal quality.

In the above-descried embodiment, the planar doped layer is provided in one location in the upper barrier layer, but it may be also provided in the lower barrier layer or in the upper and lower barrier layers. Further, the planar doped layer may be provided in two or more locations in the same barrier layer, rather than in one location. When the planar doped layer is provided in two or more locations in the same barrier layer, the distance between the planar doped layers is set to 2 nm to 3 nm.

As a specific structure, the semiconductor substrate 1 is a semi-insulating InP substrate, semi-insulating GaAs substrate, or Si substrate. In the case of an InP HEMT, an InAlAs/InGaAs heterostructure is formed on the semi-insulating InP substrate, semi-insulating GaAs substrate, or Si substrate. When the heterostructure is formed on the semi-insulating InP substrate, the buffer layer 2 can use $In_{0.52}Al_{0.48}As$ same as in the lower barrier layer 3. By contrast, when the heterostructure is formed on the semi-insulating GaAs substrate or Si substrate, using a composition-graded semiconductor layer (in this case, the lattice constant is made to increase gradually) as the buffer layer 2 and forming the layer such that the lattice constant of the uppermost portion of the buffer layer 2 matches the lattice constant of the $In_{0.52}Al_{0.48}As$ lower barrier layer 3 are needed. In the case of a GaAs HEMT, an AlGaAs/(In)GaAs heterostructure is formed on the semi-insulating GaAs substrate or Si substrate. When the heterostructure is formed on the semi-insulating GaAs substrate, the buffer layer 2 can use AlGaAs same as in the lower barrier layer 3. By contrast, when the heterostructure is formed on the Si substrate, using a composition-graded semiconductor layer (in this case, the lattice constant is made to increase gradually) as the buffer layer 2 and forming the layer such that the lattice constant of the uppermost portion of the buffer layer 2 matches the lattice constant of the AlGaAs lower barrier layer 3 are needed. There are a great variety of buffer layer structures, and the structure of this layer cannot be uniquely defined.

When a semi-insulating InP substrate is used, the lower barrier layer 3 is an InAlAs layer, and the channel layer 4 is an InGaAs layer or a laminated structure of an InGaAs layer and an InAs layer. Further, a portion of the upper barrier layer 5 other than the III-V compound semiconductor spacer layer 6 is an InAlAs layer or a laminated structure of an InAlAs layer and an InP layer. The cap layer 10 is an n-type InGaAs layer or a laminated structure of an n-type InGaAs layer and an n-type InAlAs layer.

When a semi-insulating GaAs substrate is used, the lower barrier layer 3 is an AlGaAs layer, and the channel layer 4 is a GaAs layer or an InGaAs layer. A portion of the upper barrier layer 5 other than the III-V compound semiconductor spacer layer 6 is an AlGaAs layer, and the cap layer 10 is an n-type GaAs layer.

Further, the III-V compound semiconductor spacer layer is any one of the AlSb layer, AlGaSb layer, AlInSb layer, and AlGaInSb layer. A GaSb layer is conductive, but when the Ga composition ratio is small, no problem is associated with the AlGaSb layer or AlGaInSb layer.

An insulating film may be provided on the exposed flat surface of the cap layer, and the foot portion of the gate electrode can be supported by causing the side end surface of the opening provided in the insulating film to abut against the side end surface of the gate electrode.

In the embodiments of the present invention, a very thin layer of AlSb in which Si is ionized and does not become a donor is provided in the spacer portion in the barrier layer. Therefore, where the electron concentration in the channel layer is to be increased by increasing Si-$\delta$ doping which provides an electron supply layer, even though Si diffuses close to the channel layer in the spacer layer, it does not become the remote Coulomb scattering source and the electron mobility in the channel layer does not decrease.

EXAMPLE 1

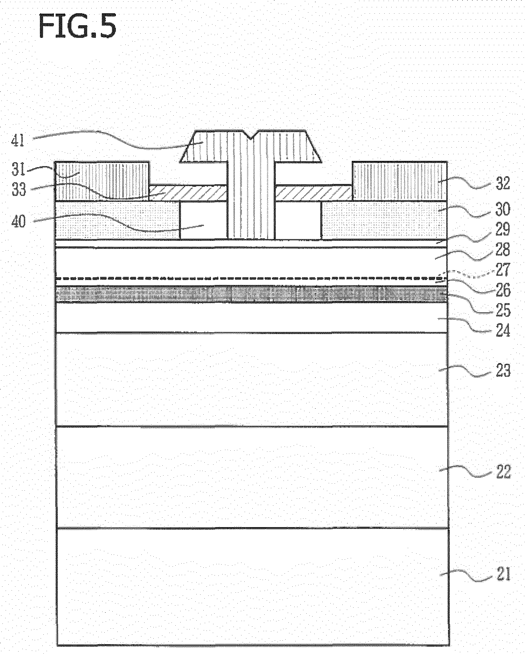

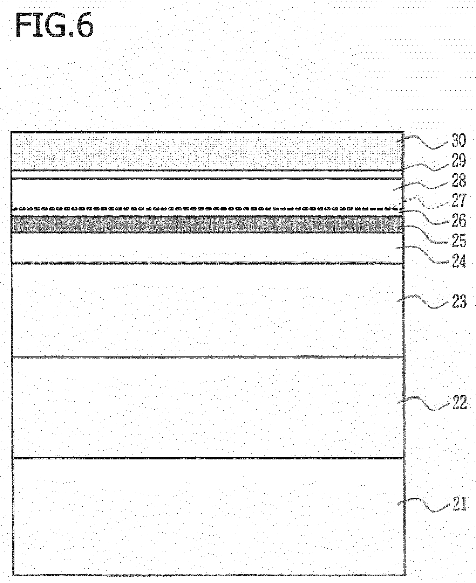

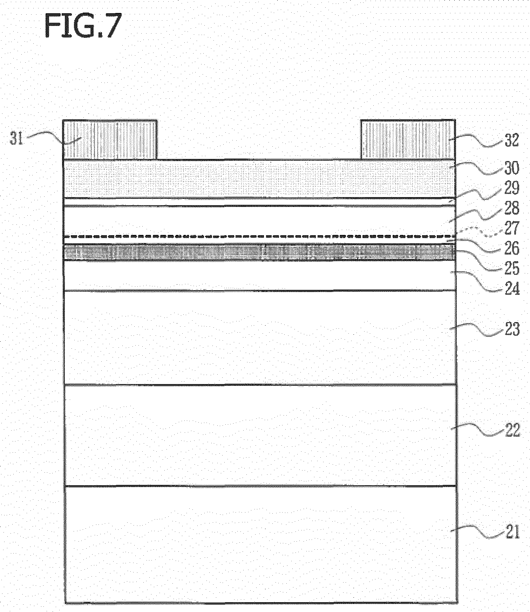

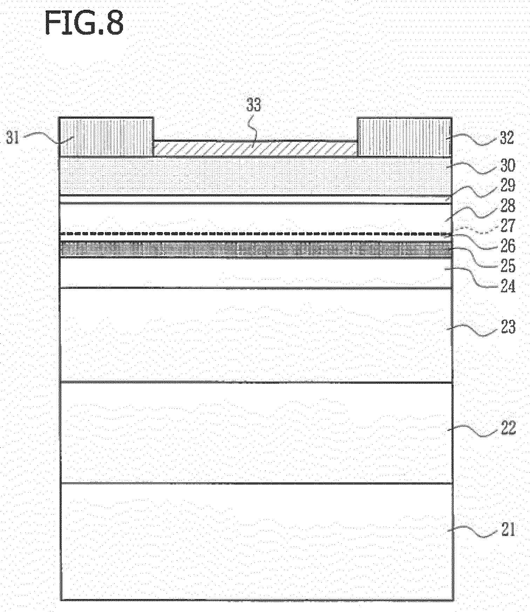

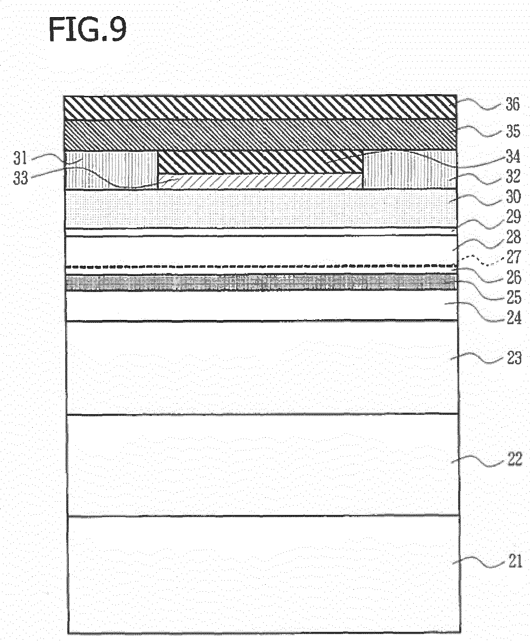

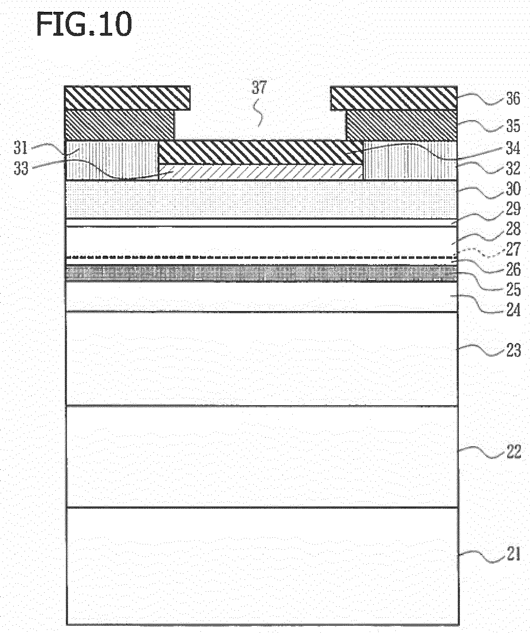

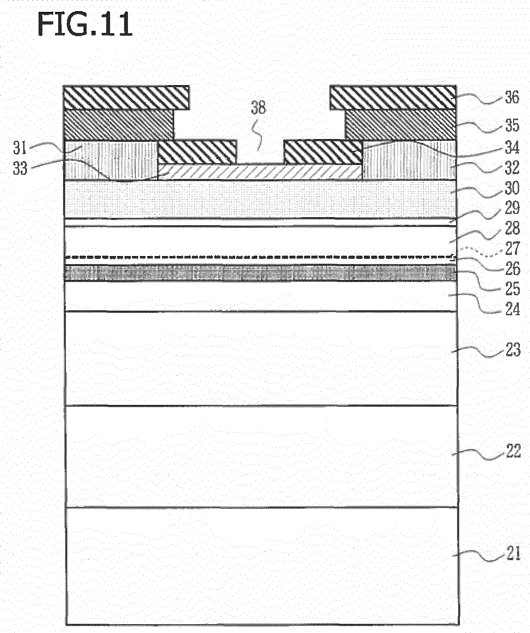

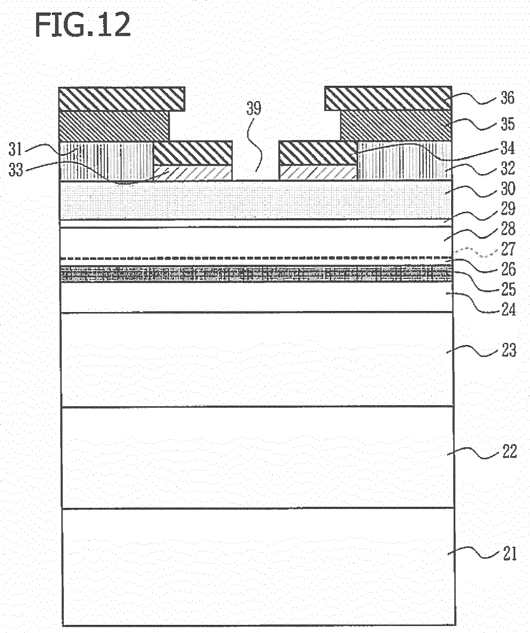

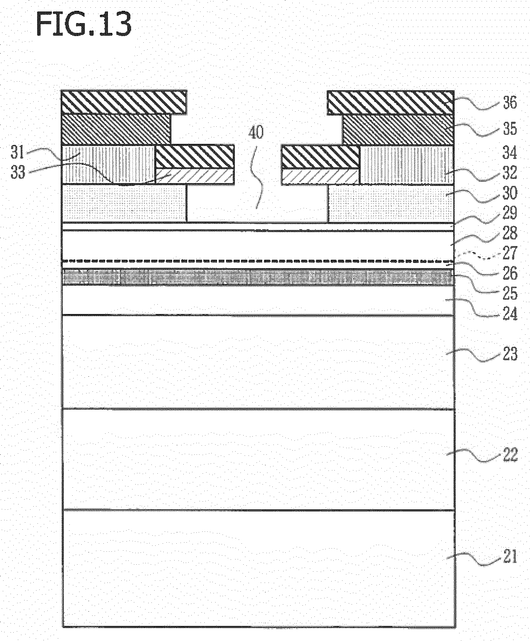

The HEMT of Example 1 of the present invention will be explained hereinbelow with reference to Figs. 5 to 15. Fig.5 is a schematic cross-sectional view of the HEMT of Example 1 of the present invention. As illustrated in the figure, an i-type $In_{0.52}Al_{0.48}As$ buffer layer 22, an i-type $In_{0.52}Al_{0.48}As$ lower barrier layer 23, and an i-type InGaAs channel layer 24 are successively deposited on a semi-insulating InP substrate 21. Then, an i-type AlSb spacer layer 25 and an i-type $In_{0.52}Al_{0.48}As$ spacer layer 26 are successively deposited, and a $\delta$ doped layer 27 is thereafter formed by $\delta$ doping of Si.
Then, an i-type $In_{0.52}Al_{0.48}As$ barrier layer 28 and an i-type InP layer 29 are successively deposited. The i-type AlSb spacer layer 25 through the i-type InP layer 29 constitute the upper barrier layer. The i-type InP layer 29 is provided to prevent the exposure of the i-type $In_{0.52}Al_{0.48}As$ barrier layer 28 which is an Al-containing layer. Then, a source electrode 31 and a drain electrode 32 are provided, with an n-type InGaAs cap layer 30 being provided therebelow. A gate electrode 41 is provided in a gate recess portion 40.
Thus, in Example 1 of the present invention, the i-type AlSb spacer layer in which Si is ionized and does not become a donor is provided at the interface with the i-type InGaAs channel layer 24. Therefore, the effect of remote Coulomb scattering can be greatly reduced.
A process for manufacturing the HEMT of Example 1 of the present invention will be explained hereinbelow with reference to Figs. 6 to 15. Initially, as illustrated in Fig. 6, the i-type $In_{0.52}Al_{0.48}As$ buffer layer 22 with a thickness of 1000 nm, the i-type $In_{0.52}Al_{0.48}As$ layer lower barrier layer 23 with a thickness of 200 nm, and the i-type InGaAs channel layer 24 with a thickness of 10 nm are deposited by the MBE method on the semi-insulating InP substrate 21. Then, the i-type AlSb spacer layer 25 with a thickness of 2 nm and the i-type $In_{0.52}Al_{0.48}As$ spacer layer 26 with a thickness of 1 nm are deposited.
Then, the $\delta$ doped layer 27 is formed by using a cell containing a solid Si source and performing $\delta$ doping of Si. The $\delta$ doping amount of Si is taken as $1 \times 10^{13}$ cm$^{-2}$. Then, the i-type $In_{0.52}Al_{0.48}As$ barrier layer 28 with a thickness of 6 nm, the i-type InP layer 29 with a thickness of 3 nm, and the n-type InGaAs cap layer 30 with a thickness of 20 nm are deposited. The composition of the i-type InGaAs channel layer 24 is $In_xGa_{1-x}As$ ($0.8 \geq x \geq 0.53$), and the composition of the n-type InGaAs cap layer 30 is $In_{0.53}Ga_{0.47}As$. The time of the growth process after the $\delta$ doping is about 3 min. The impurity concentration in the n-type InGaAs cap layer 30 is $2 \times 10^{19}$ cm$^{-3}$.
Then, the laminated structure provided on the wafer is divided into element regions, and the source electrode 31 and the drain electrode 32 are thereafter formed by depositing metal electrodes constituted by a Ti/Pt/Au laminated structure on the n-type InGaAs cap layer 30, as illustrated in Fig. 7.
Then, as illustrated in Fig. 8, a $SiO_2$ film 33 with a thickness of 20 nm is formed on the n-type InGaAs cap layer 30 between the source electrode 31 and the drain electrode 32 by using a plasma CVD method.
Then, as illustrated in Fig. 9, a first resist layer 34 is formed on the $SiO_2$ film 33 in the recess portion between the source electrode 31 and the drain electrode 32, and a second resist layer 35 and a third resist layer 36 are formed on the first resist layer. In this case, an electron beam resist ZEP (trade name, ZEON CORPORATION) is used as the first resist layer 34 and the third resist layer 36. Further, PMGI (Poly-dimethylglutarimide: manufactured by MicroChem Corp., trade name) is used as the second resist layer 35. The thickness of the first resist layer 34 changes depending on the length of the foot portion of the gate electrode. For this reason, in Figs. 9 to 14, the thickness of the first resist layer 34 represents the uppermost portion of the metal used for the source electrode 31 and the drain electrode 32, but the thickness can be larger or smaller than this. When the thickness is large, the first resist layer 34 covers both the source electrode 31 and the drain electrode 32. When the thickness is small, the second resist layer 35 penetrates between the source electrode 31 and the drain electrode 32.
Then, as illustrated in Fig. 10, the head portion of the T-shaped gate electrode is exposed by the electron beam exposure method and an opening 37 is formed by developing the third resist layer 36 and the second resist layer 35. Then, as illustrated in Fig. 11, highly accurate exposure of the first resist layer 34 is further performed by the electron beam exposure method to match the target gate length, and an opening 38 corresponding to the foot portion of the T-shaped gate electrode is formed.
Then, as illustrated in Fig. 12, an opening 39 is formed by removing the exposed portion of the $SiO_2$ film 33 by reactive ion etching by using the first resist layer 34, in which the opening 38 has been formed, as a mask. $CF_4$ is used as the etching gas.
Then, as illustrated in Fig. 13, the n-type InGaAs cap layer 30 is etched by performing wet etching using the $SiO_2$ film 33, in which the opening 39 has been formed, as a mask, thereby forming a gate recess portion 40 and electrically separating the n-type InGaAs cap layer 30. A mixed solution of citric acid ($C_6H_8O_7$) and hydrogen peroxide

($H_2O_2$) is used as the etching solution.

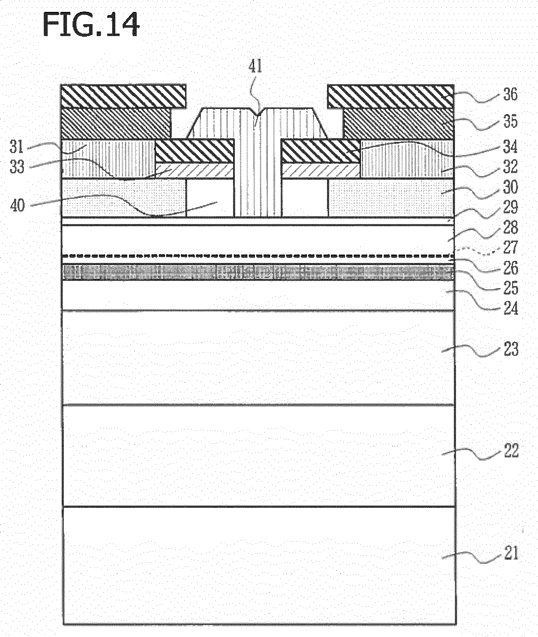

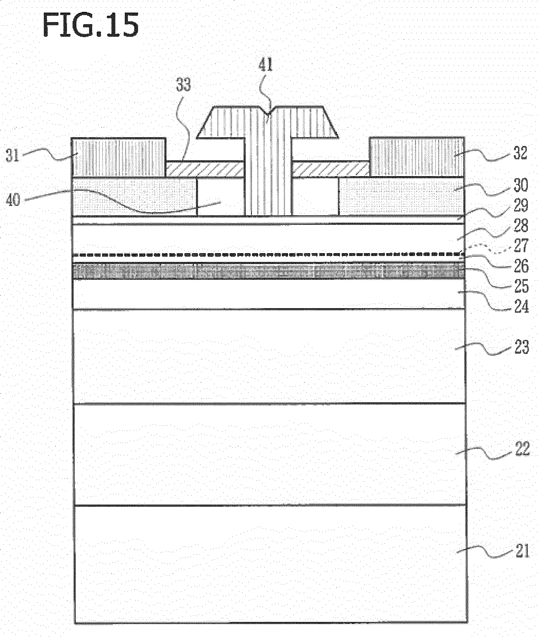

Then, as illustrated in Fig. 14, a Ti/Pt/Au laminated film is vapor deposited as a gate electrode 41. Then, as illustrated in Fig. 15, layers from the third resist layer 36 through the first resist layer 34 are removed and the Ti/Pt/Au laminated film deposited on the third resist layer 36 is also removed by lift-off, thereby producing the basic structure of the HEMT of Example 1 of the present invention.

EXAMPLE 2

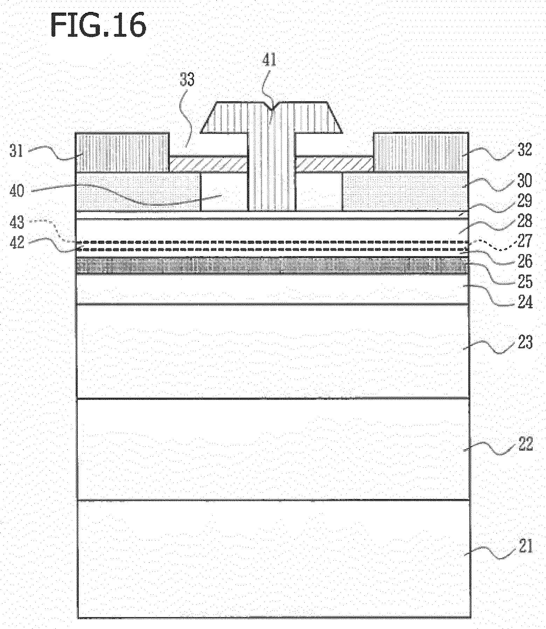

The HEMT of Example 2 of the present invention will be explained hereinbelow with reference to Fig. 16. In the HEMT of Example 2, Si-$\delta$ doping is performed twice in the upper barrier layer. Other features, namely, the thickness of the layers, impurity concentrations, and compositions are the same as in Example 1. Fig. 16 is a schematic cross-sectional view of the HEMT of Example 2 of the present invention. As illustrated in the figure, the i-type $In_{0.52}Al_{0.48}AS$ buffer layer 22, the i-type $In_{0.52}Al_{0.48}As$ lower barrier layer 23, and the i-type InGaAs channel layer 24 are successively deposited on the semi-insulating InP substrate 21. Then, the i-type AlSb spacer layer 25 and the i-type $In_{0.52}Al_{0.48}As$ spacer layer 26 are successively deposited, and the $\delta$ doped layer 27 is thereafter formed by $\delta$ doping of Si.

Then, the i-type $In_{0.52}Al_{0.48}As$ spacer layer 42 with a thickness of 2 nm is deposited and then the $\delta$ doped layer 43 is formed by again performing the Si-$\delta$ doping to about $1 \times 10^{13}$ cm$^{-2}$. Then, again, the i-type $In_{0.52}Al_{0.48}AS$ barrier layer 28 and the i-type InP layer 29 are successively deposited in the same manner as in Example 1. The layers from the i-type AlSb spacer layer 25 through the i-type InP layer 29 constitute the upper barrier layer. Then, the source electrode 31 and the drain electrode 32 are provided, with the n-type InGaAs cap layer 30 being provided therebelow. The gate electrode 41 is provided in the gate recess portion 40.

Thus, in Example 2 of the present invention, the i-type AlSb spacer layer is provided at the interface with the i-type InGaAs channel layer 24. Therefore, although two $\delta$ doped layers are provided and the carrier supply capacity is increased, the effect of remote Coulomb scattering can be greatly reduced.

EXAMPLE 3

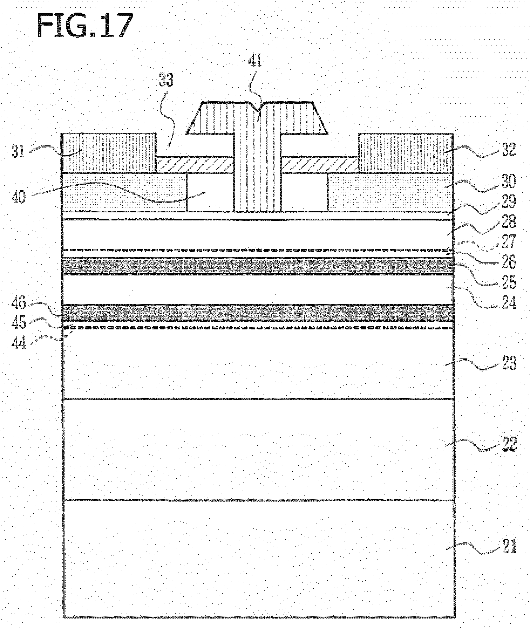

The HEMT of Example 3 of the present invention will be explained hereinbelow with reference to Fig. 17. In the HEMT of Example 3, the Si-$\delta$ doping is performed in the lower barrier layer. Other features, namely, the thickness of the layers, impurity concentrations, and compositions are the same as in Example 1. Fig. 17 is a schematic cross-sectional view of the HEMT of Example 3 of the present invention. As illustrated in the figure, the i-type $In_{0.52}Al_{0.48}As$ buffer layer 22 and the i-type $In_{0.52}Al_{0.48}As$ lower barrier layer 23 are successively deposited on the semi-insulating InP substrate 21.

Then, a $\delta$ doped layer 44 is formed by performing the Si-$\delta$ doping to about $1 \times 10^{13}$ cm$^{-2}$, and an i-type $In_{0.52}Al_{0.48}As$ spacer layer with a thickness of 1 nm and an i-type AlSb spacer layer 46 with a thickness of 2 nm are thereafter formed. The i-type InGaAs channel layer 24, i-type AlSb spacer layer 25, and i-type $In_{0.52}Al_{0.48}As$ spacer layer 26 are then successively formed and the $\delta$ doped layer 27 is formed by $\delta$ doping of Si in the same manner as in Example 1.

Then, the i-type $In_{0.52}Al_{0.48}As$ barrier layer 28 and the i-type InP layer 29 are successively deposited. The source electrode 31 and the drain electrode 32 are then provided, with the n-type InGaAs cap layer 30 being provided therebelow. The gate electrode 41 is provided in the gate recess portion 40.

Thus, in Example 3 of the present invention, the carrier supply capacity is increased by providing the $\delta$ doped layer in the upper and lower barrier layers, but because the AlSb spacer layer is provided on the interfaces of the upper and lower barrier layers with the channel layer, the effect of remote Coulomb scattering can be greatly reduced.

EXAMPLE 4

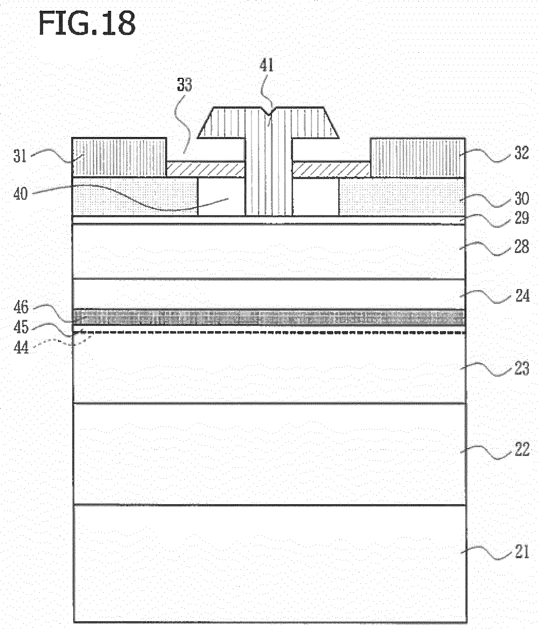

The HEMT of Example 4 of the present invention will be explained hereinbelow with reference to Fig. 18. In the HEMT of Example 4, the Si-$\delta$ doping is performed on the lower barrier layer side, by contrast with Example 1. Other features, namely, the thickness of the layers, impurity concentrations, and compositions are the same as in Example 1. Fig. 18 is a schematic cross-sectional view of the HEMT of Example 4 of the present invention. As illustrated in the figure, the i-type $In_{0.52}Al_{0.48}As$ buffer layer 22 and the i-type $In_{0.52}Al_{0.48}As$ lower barrier layer 23 are successively deposited on the semi-insulating InP substrate 21.

Then, a $\delta$ doped layer 44 is formed by performing the Si-$\delta$ doping to about $1 \times 10^{13}$ cm$^{-2}$, and the i-type $In_{0.52}Al_{0.48}AS$ spacer layer 45 with a thickness of 1 nm and the i-type AlSb spacer layer 46 with a thickness of 2 nm are thereafter formed. The i-type InGaAs channel layer 24, the i-type $In_{0.52}Al_{0.48}As$ barrier layer 28 and the i-type InP layer 29 are then successively deposited. The source electrode 31 and the drain electrode 32 are then provided, with the n-type InGaAs cap layer 30 being provided therebelow. The gate electrode 41 is provided in the gate recess portion 40.

Thus, in Example 4 of the present invention, the δ doped layer is provided in the lower barrier layer, but because the AlSb spacer layer is provided on the interface of the lower barrier layer with the channel layer, the effect of remote Coulomb scattering can be greatly reduced.

EXAMPLE 5

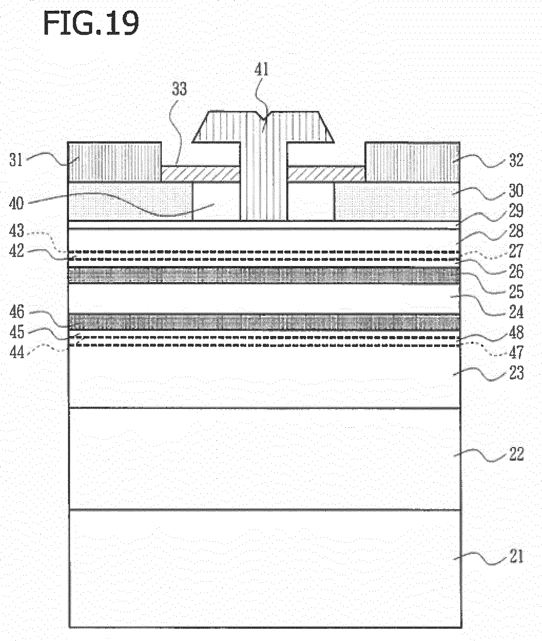

The HEMT of Example 5 of the present invention will be explained hereinbelow with reference to Fig. 19. In the HEMT of Example 5, the Si-δ doping is performed twice in either of the upper and lower barrier layers. Other features, namely, the thickness of the layers, impurity concentrations, and compositions are the same as in Example 1. Fig. 19 is a schematic cross-sectional view of the HEMT of Example 5 of the present invention. As illustrated in the figure, the i-type $In_{0.52}Al_{0.48}AS$ buffer layer 22 and the i-type $In_{0.52}Al_{0.48}As$ lower barrier layer 23 are successively deposited on the semi-insulating InP substrate 21.

Then, a δ doped layer 47 is formed by performing the Si-δ doping to about $1 \times 10^{13}$ cm$^{-2}$, and then the i-type $In_{0.52}Al_{0.48}As$ spacer layer 48 with a thickness of 2 nm is formed. The δ doped layer 44 is then formed by again performing the Si-δ doping to about $1 \times 10^{13}$ cm$^{-2}$, and the i-type $In_{0.52}Al_{0.48}As$ spacer layer 45 with a thickness of 1 nm and the i-type AlSb spacer layer 46 with a thickness of 2 nm are thereafter formed.

The i-type InGaAs channel layer 24, the i-type AlSb spacer layer 25, and the i-type $In_{0.52}Al_{0.48}As$ spacer layer 26 are then successively deposited, and the δ doped layer 27 is then formed by δ doping of Si. The i-type $In_{0.52}Al_{0.48}As$ spacer layer 42 with a thickness of 2 nm is then deposited, and the δ doped layer 43 is then formed by again performing the Si-δ doping to about $1 \times 10^{13}$ cm$^{-2}$. The i-type $In_{0.52}Al_{0.48}As$ spacer barrier 28 and the i-type InP layer 29 are then successively deposited in the same manner as in Example 1. The source electrode 31 and the drain electrode 32 are then provided, with the n-type InGaAs cap layer 30 being provided therebelow. The gate electrode 41 is provided in the gate recess portion 40.

Thus, in Example 5 of the present invention, the carrier supply capacity is further increased by providing two δ doped layers in the upper and lower barrier layers, but because the AlSb spacer layer is provided on the interfaces of the upper and lower barrier layers with the channel layer, the effect of remote Coulomb scattering can be greatly reduced.

EXAMPLE 6

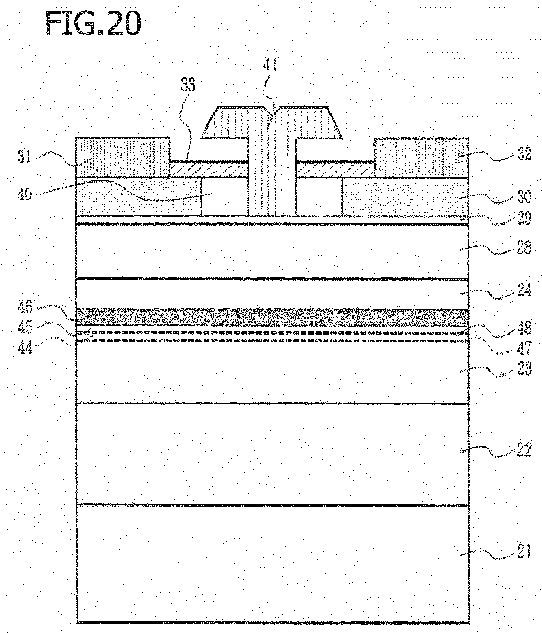

The HEMT of Example 6 of the present invention will be explained hereinbelow with reference to Fig. 20. In the HEMT of Example 6, the Si-δ doping is performed twice only in the lower barrier layer. Other features, namely, the thickness of the layers, impurity concentrations, and compositions are the same as in Example 1. Fig. 20 is a schematic cross-sectional view of the HEMT of Example 6 of the present invention. As illustrated in the figure, the i-type $In_{0.52}Al_{0.48}As$ buffer layer 22 and the i-type $In_{0.52}Al_{0.48}As$ lower barrier layer 23 are successively deposited on the semi-insulating InP substrate 21.

Then, the δ doped layer 47 is formed by performing the Si-δ doping to about $1 \times 10^{13}$ cm$^{-2}$, and then the i-type $In_{0.52}Al_{0.48}As$ spacer layer 48 with a thickness of 2 nm is formed. The δ doped layer 44 is then formed by again performing the Si-δ doping to about $1 \times 10^{13}$ cm$^{-2}$, and the i-type $In_{0.52}Al_{0.48}As$ spacer layer 45 with a thickness of 1 nm and the i-type AlSb spacer layer 46 with a thickness of 2 nm are thereafter formed.

The i-type InGaAs channel layer 24, the i-type $In_{0.52}Al_{0.48}AS$ spacer barrier 28, and the i-type InP layer 29 are then successively deposited. The source electrode 31 and the drain electrode 32 are then provided, with the n-type InGaAs cap layer 30 being provided therebelow. The gate electrode 41 is provided in the gate recess 40.

Thus, in Example 6 of the present invention, the carrier supply capacity is increased by providing two 5 doped layers in the lower barrier layer, but because the AlSb spacer layer is provided on the interface of the lower barrier layer with the channel layer, the effect of remote Coulomb scattering can be greatly reduced.

EXAMPLE 7

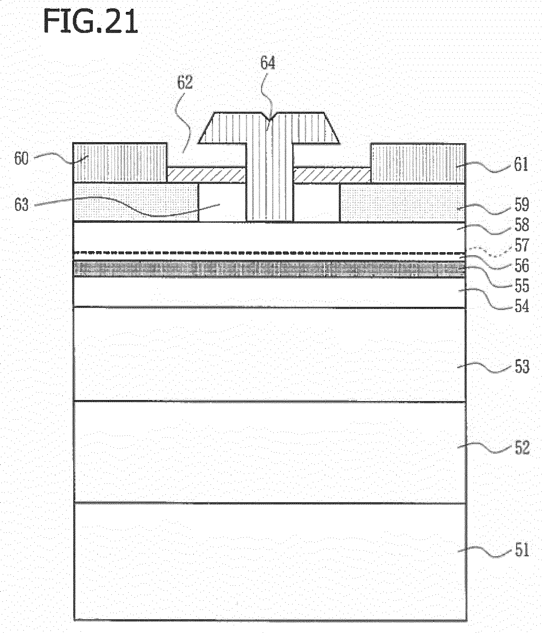

The HEMT of Example 7 of the present invention will be explained hereinbelow with reference to Fig. 21. The HEMT of Example 7 is a GaAs HEMT with a GaAs substrate. The basic configuration thereof is the same as in Example 1. Fig. 21 is a schematic cross-sectional view of the HEMT of Example 7 of the present invention. As illustrated in the figure, and i-type AlGaAs buffer layer 52 with a thickness of 1000 nm and an i-type AlGaAs lower barrier layer 53 with a thickness of 200 nm are successively deposited on a semi-insulating GaAs substrate 51.

Then, an i-type InGaAs channel layer 54 with a thickness of 10 nm, an i-type AlSb spacer layer 55 with a thickness of 2 nm, and an i-type AlGaAs spacer layer 56 with a thickness of 1 nm are successively deposited, and a δ doped layer 57 is formed by δ doping of Si. An i-type AlGaAs buffer layer 58 with a thickness of 6 nm and an n-type GaAs cap layer 59 with an impurity concentration of $2 \times 10^{19}$ cm$^{-3}$ and a thickness of 20 nm are then deposited. A source electrode 60 and a drain electrode 61 are then provided, with an n-type GaAs cap layer 59 being provided therebelow. A gate electrode 64 is provided in the gate recess 63. In the GaAs HEMT, a SiO$_2$ film 62 is also provided on the exposed flat surface of an n-type GaAs cap layer 59.

Thus, in Example 7 of the present invention, a GaAs HEMT is provided in which the substrate is from GaAs, but the circumstances of remote Coulomb diffusion which follows the increase in impurity concentration in the δ doped layer are the same as in the InP HEMT. In this case, since the AlSb spacer layer is provided on the interface of the AlGaAs barrier layer, which has been provided with the δ doped layer, with the channel layer, the effect of remote Coulomb scattering can be greatly reduced. Further, in this Example 7, the δ doped layer is provided only on the upper barrier layer side, as in the above-described Example 1. However, the δ doped layer may be also provided in the lower barrier layer or the upper and lower barrier layers, or a plurality of δ doped layers may be provided in the same barrier layer in the same manner as in Examples 2 to 6. Further, in Example 7, the channel layer is from InGaAs, but GaAs may be also used therefor.

REFERENCE SIGNS LIST

| | |
|---|---|
| 1 | semiconductor substrate |
| 2 | buffer layer |
| 3 | lower barrier layer |
| 4 | channel layer |
| 5 | upper barrier layer |
| 6 | III-V group compound semiconductor spacer layer in which a V group element is Sb |
| 7 | spacer layer |
| 8 | planar doped layer |
| 9 | barrier layer |
| 10 | cap layer |
| 11 | source electrode |
| 12 | drain electrode |
| 13 | gate electrode |
| 21, 71 | semi-insulating InP substrates |
| 22, 72 | i-type In$_{0.52}$Al$_{0.48}$As buffer layers |
| 23, 73 | i-type In$_{0.52}$Al$_{0.48}$As lower barrier layers |
| 24, 74 | i-type InGaAs channel layers |
| 25, 46 | i-type AlSb spacer layers |
| 26, 42, 45, 48, 75 | i-type In$_{0.52}$Al$_{0.48}$As spacer layers |
| 27, 43, 44, 47, 76 | δ doped layers |
| 28, 77 | i-type In$_{0.52}$Al$_{0.48}$As barrier layers |
| 29, 78 | i-type InP layers |
| 30, 79 | n-type InGaAs cap layers |
| 31, 80 | source electrodes |
| 32, 81 | drain electrodes |
| 33 | SiO$_2$ film |
| 34 | first resist layer |
| 35 | second resist layer |
| 36 | third resist layer |
| 37, 38, 39 | openings |
| 40, 82 | gate recess portions |
| 41, 83 | gate electrodes |
| 51 | semi-insulating GaAs substrate |
| 52 | i-type AlGaAs buffer layer |
| 53 | i-type AlGaAs lower barrier layer |
| 54 | i-type InGaAs channel layer |
| 55 | i-type AlSb spacer layer |
| 56 | i-type AlGaAs spacer layer |
| 57 | δ doped layer |
| 58 | i-type AlGaAs barrier layer |
| 59 | n-type GaAs cap layer |
| 60 | source electrode |

| 61 | drain electrode |
| 62 | $SiO_2$ film |
| 63 | gate recess portion |
| 64 | gate electrode |

## Claims

1. A field-effect compound semiconductor device comprising:

a semiconductor substrate;
a lower barrier layer that is provided on the semiconductor substrate;
a channel layer that is provided in contact with the lower barrier layer;
an upper barrier layer that is provided in contact with the channel layer;
a cap layer that is provided in contact with the upper barrier layer;
a source electrode and a drain electrode that are provided on the cap layer; and
a gate electrode that is arranged between the source electrode and the drain electrode, wherein
a planar doped layer that is planarly doped with impurity atoms, which are to be a channel electron supply source, is provided in at least one of the lower barrier layer and the upper barrier layer; and
a portion of the barrier layer, where the planar doped layer has been provided, is a III-V group compound semiconductor spacer layer in which a V group element is Sb, with this portion being in contact with the channel layer.

2. The field-effect compound semiconductor device according to claim 1, wherein a buffer layer is provided between the semiconductor substrate and the lower barrier layer.

3. The field-effect compound semiconductor device according to claim 1 or 2, wherein a plurality of the planar doped layers are provided in one barrier layer.

4. The field-effect compound semiconductor device according to any one of claims 1 to 3, wherein
the lower barrier layer is an InAlAs layer;
the channel layer is an InGaAs layer or a laminated structure of an InGaAs layer and an InAs layer;
a portion of the upper barrier layer other than the III-V group compound semiconductor spacer layer is an InAlAs layer or a laminated structure of an InAlAs layer and an InP layer;
the cap layer is an n-type InGaAs layer or a laminated structure of an n-type InGaAs layer and an n-type InAlAs layer.

5. The field-effect compound semiconductor device according to any one of claims 1 to 3, wherein
the lower barrier layer is an AlGaAs layer;
the channel layer is a GaAs layer or an InGaAs layer;
a portion of the upper barrier layer other than the III-V group compound semiconductor spacer layer is an AlGaAs layer;
the cap layer is an n-type GaAs layer.

6. The field-effect compound semiconductor device according to any one of claims 1 to 5, wherein
the impurity atom doped into the planar doped layer is Si.

7. The field-effect compound semiconductor device according to any one of claims 1 to 6, wherein the III-V group compound semiconductor spacer layer is any of an AlSb layer, an AlGaSb layer, an AlInSb layer, and an AlGaInSb layer.

8. The field-effect compound semiconductor device according to any one of claims 1 to 7, wherein the thickness of the III-V group compound semiconductor spacer layer is 50% to 80% of the thickness between a central position of the planar doped layer and the channel layer.

9. The field-effect compound semiconductor device according to any one of claims 1 to 8, wherein
an insulating film is provided on an exposed flat surface of the cap layer; and
a side end surface of an opening provided in the insulating film abuts against a side end surface of the gate electrode.

FIG.1

FIG.2

FIG.3

FIG.4

FIG.5

41

31
33

40

32

30
29
28
27
26
25
24

23

22

21

FIG.6

30
29
28
27
26
25
24
23
22
21

FIG.7

FIG.8

FIG.9

FIG.10

FIG.11

FIG.12

FIG.13

FIG.14

# FIG.15

FIG.16

FIG.17

FIG.18

FIG.19

# FIG.20

FIG.21

FIG.22

EP 3 038 143 A1

FIG.23A

BARRIER
LAYER

CHANNEL
LAYER

δ DOPING

FIG.23B

BARRIER
LAYER

CHANNEL
LAYER

δ DOPING

34

**INTERNATIONAL SEARCH REPORT**

International application No.

PCT/JP2013/072061

| A. CLASSIFICATION OF SUBJECT MATTER |
|---|
| *H01L21/338*(2006.01)i, *H01L21/225*(2006.01)i, *H01L29/778*(2006.01)i, *H01L29/812*(2006.01)i |

According to International Patent Classification (IPC) or to both national classification and IPC

| B. FIELDS SEARCHED |
|---|
| Minimum documentation searched (classification system followed by classification symbols)<br>H01L29/80-29/812, H01L29/778; 21/337-21/338 |

Documentation searched other than minimum documentation to the extent that such documents are included in the fields searched
Jitsuyo Shinan Koho          1922-1996   Jitsuyo Shinan Toroku Koho   1996-2013
Kokai Jitsuyo Shinan Koho    1971-2013   Toroku Jitsuyo Shinan Koho   1994-2013

Electronic data base consulted during the international search (name of data base and, where practicable, search terms used)

| C. DOCUMENTS CONSIDERED TO BE RELEVANT |

| Category* | Citation of document, with indication, where appropriate, of the relevant passages | Relevant to claim No. |
|---|---|---|
| X<br>A | WO 2010/074906 A2  (INTEL CORP.),<br>01 July 2010 (01.07.2010),<br>fig. 1; page 2, line 31 to page 8, line 31;<br>page 9, line 29 to page 10, line 2<br>& JP 2012-510172 A       & EP 2359405 A<br>& CN 102171831 A        & KR 10-2011-0051271 A<br>& TW 201034196 A | 1-3,6-9<br>4,5 |
| A | JP 2010-225906 A  (Asahi Kasei EMD Corp.),<br>07 October 2010 (07.10.2010),<br>paragraphs [0027] to [0047]; fig. 1<br>(Family: none) | 1-9 |

☒ Further documents are listed in the continuation of Box C.       ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>28 August, 2013 (28.08.13) | Date of mailing of the international search report<br>10 September, 2013 (10.09.13) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2013/072061

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2012-43937 A  (Nippon Telegraph and Telephone Corp.), 01 March 2012 (01.03.2012), fig. 4; paragraphs [0029] to [0038], [0047] (Family: none) | 1-9 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **KIM et al.** *IEDM Tech. Dig.,* 06 December 2011, (13
- **LEUTHER et al.** *Proc. 23rd IPRM,* May 2011, vol. 2 (4), 295
- **M. E. GREINER ; J. F. GIBBONSET.** *Appl. Phys. Lett.,* 1984, vol. 44, 750